# EUROPEAN PATENT SPECIFICATION

(11) **EP 0 665 584 B1**
(45) Date of publication and mention of the grant of the patent: **07.04.1999**
(21) Application number: 95200178.2
(22) Date of filing: 25.01.1995
(51) Int. Cl.: H01L 21/56, B29C 33/68

(54) **Method for encasing an electronic component with a hardening plastic**
Verfahren zum Umhüllen eines elektronischen Bauteils mit härtbarem Kunststoff
Procédé pour enfermer un composant électronique avec du plastique durcissable

(30) Priority: 27.01.1994 NL 9400119
(43) Date of publication of application: 02.08.1995
(73) Proprietor: " 3P" LICENSING B.V., NL-6902 PA Zevenaar (NL)
(72) Inventor: Pas, Ireneus Johannes Theodorus Maria, NL-6891 AG Rozendaal (NL)
(74) Representative: Timmers, Cornelis Herman Johannes

(56) References cited:
- EP-A- 0 350 179
- EP-A- 0 442 152
- WO-A-91/10546
- FR-A- 2 103 917
- PATENT ABSTRACTS OF JAPAN vol. 013 no. 240 (E-767) ,6 June 1989 & JP-A-01 044026 (MICHIO OSADA) 16 February 1989,
- PATENT ABSTRACTS OF JAPAN vol. 013 no. 062 (E-715) ,13 February 1989 & JP-A-63 250846 (HITACHI LTD) 18 October 1988,
- PATENT ABSTRACTS OF JAPAN vol. 013 no. 243 (E-768) ,7 June 1989 & JP-A-01 044056 (NEC CORP) 16 February 1989,

## Description

The invention relates to a method for encasing an electronic component, in particular an integrated circuit, with a hardening plastic, in which the component is positioned in the cavity of a splittable mould, with a film, which is detachable from the walls of the cavity, placed between the component and the mould and the plastic being injected into the space between the component and the film. Such a method is known from the French patent 2103917 (MOTOROLA) based on the US patent application 60.339, filed August 3, 1970.

This known method has many advantages, such as the absence of release agent in the plastic used for the encasing, the fact that the mould is not subject to wear by the abrasive fillers in the plastic, and a good and complete detachment of the encased components from the mould.

The invention as outlined in claim 1 aims to improve this known method and is based on the insight that particularly interesting and advantageous applications arise when a film bears at the side facing the component a material consisting of a metal coating or a ceramic or glass which adheres better to the still warm injected plastic encasing the component than to the film, and thus remains adhering to the plastic encasing when the latter is removed from the mould after cooling.

With this method the material can be applied to the encasement of an electronic component either as a full coating, or as a partial coating, with the possibility to provide the outer surface of such a component with all kinds of patterns.

When the material is a glass, then this glass can be applied to the film in a pattern of light-conducting tracks, which can be combined with, or made to interact with, light-sensitive or radiation-sensitive electronic components. These light-conducting tracks can also be combined with, or made to interact with, light-transmitting or radiation-transmitting electronic components.

An advantageous way to carry out the method according to the invention is one in which the encasing is carried out in at least two successive steps, as follows:
- a first step, in which the moulding cavity walls have not yet fully reached their end position and the plastic is injected between the component and the film at such pressure that the film comes to rest in a sealing manner against the moulding cavity walls, and
- an immediately following second step, in which the moulding cavity walls are moved into the end position.

Preferably the injection pressure is maintained during the carrying out of the second step.

The invention is explained with reference to the drawing, in which:
Fig. 1 shows a section of a mould, in order to explain the method according to the invention;
Fig. 2 shows a top view of a part of the mould according to Fig. 1; and
Figs. 3A to 3E show sections of a mould, in various steps of the method according to the invention.

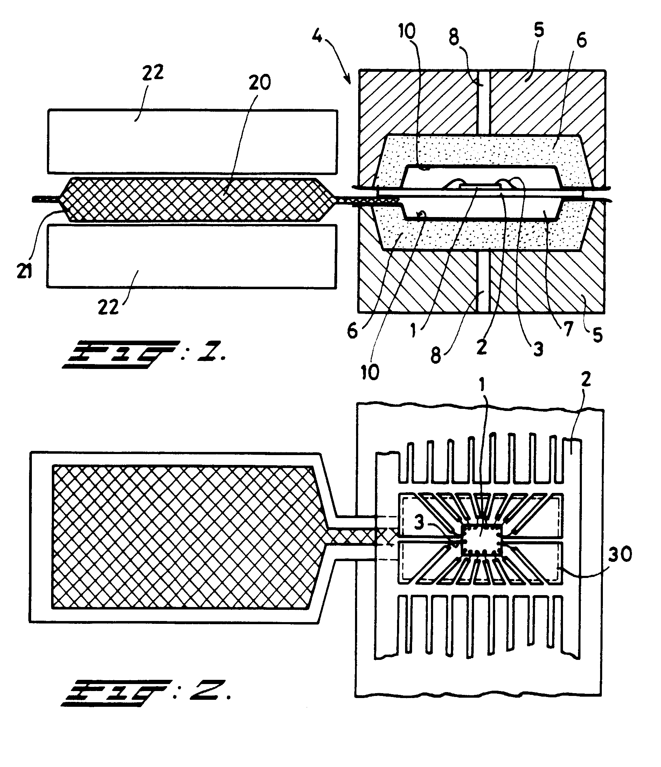

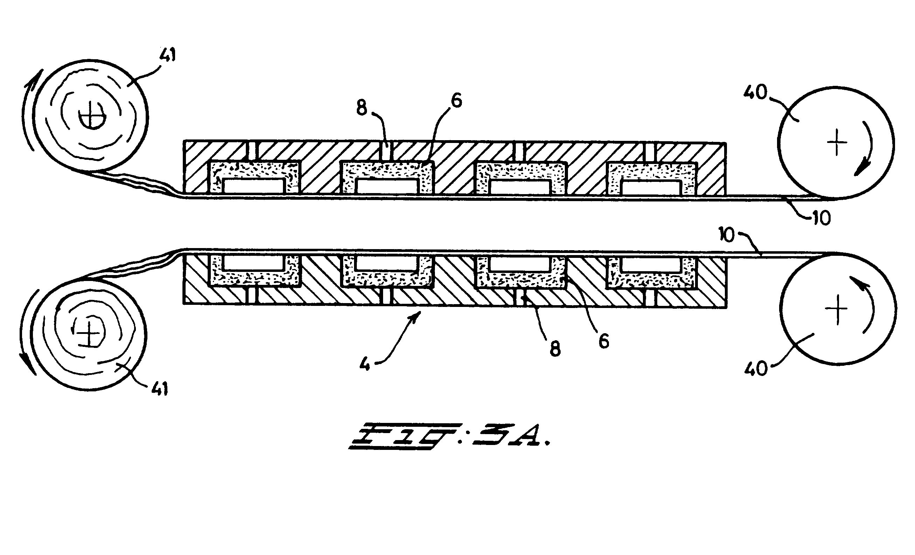

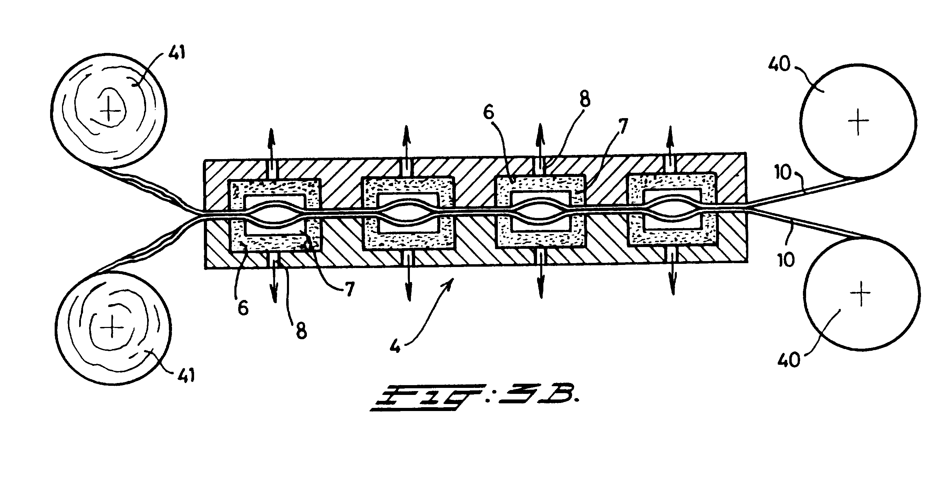

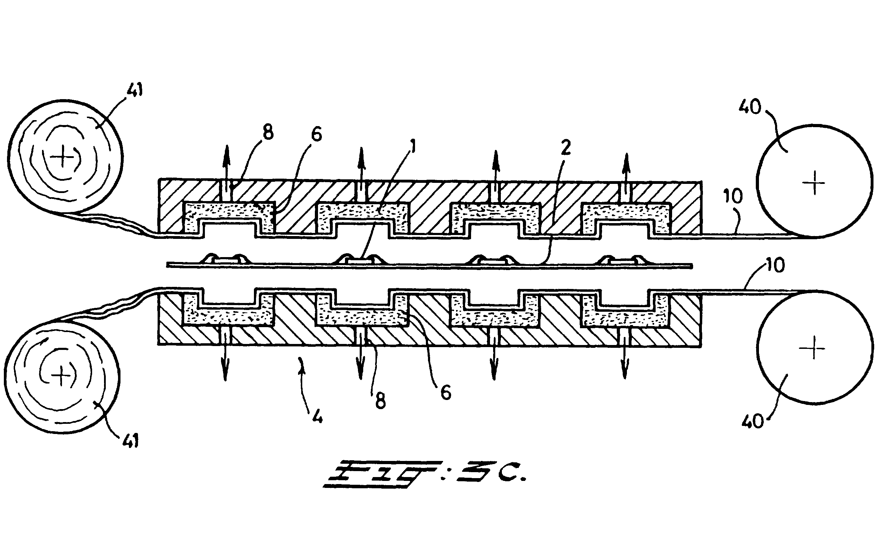

Fig. 1 shows a section of a known mould by means of which the method according to the invention can be carried out. Reference numeral 1 indicates a semi-conductor component, in particular an integrated circuit, mounted on a lead frame strip 2. The electrical connections of the semi-conductor component 1 are connected to the lead frame strip 2 by means of wires 3. The lead frame strip is clamped between two parts of the mould 4. The mould 4 consists of two shoes 5, containing porous moulding parts 6 which define cavities 7 in the mould. The shoes 5 have channels 8, by means of which air can be extracted from the moulding parts 6 or admitted to the moulding parts. Before a hardening plastic 20 is now forced into the cavity 7, the inside walls of the mould parts are covered with a stretchable film 10 which does not adhere to the plastic, and does not adhere to the mould either. The film is fitted closely against the moulding part through extraction of the air from the space between the moulding part 6 and the film 10.

The cavity 7 provided with film is subsequently filled by injecting a liquid, hardening plastic 20, for example by forcing said plastic out of a flexible encasement 21 between two pressure plates 22. For this purpose, the cavity has a vent, for example a gap in the partial face of the mould 4.

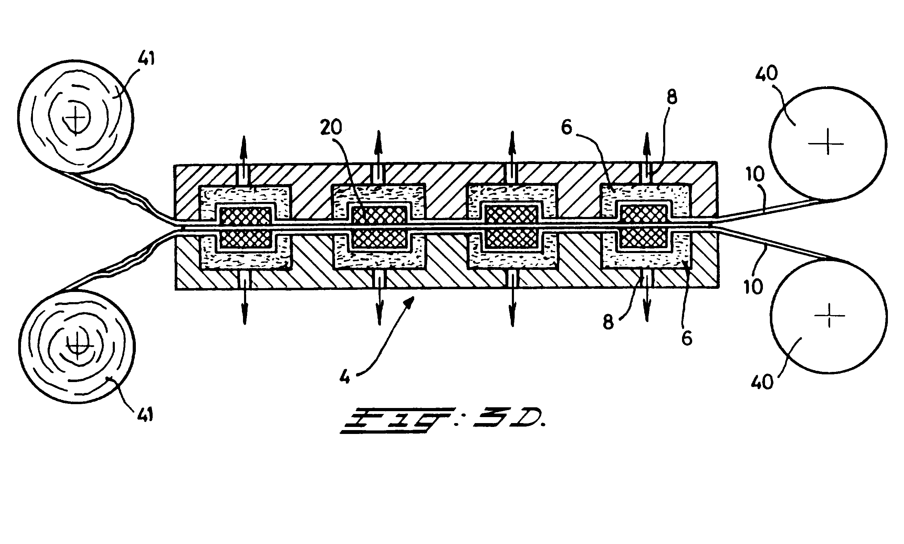

Fig. 2 shows a top view of the device according to Fig. 1, with top part 5, 6 of the mould removed and the pressure plate 22 removed. Parts with identical reference numbers to those in Fig. 1 are of the same type and have the same function.

The horizontal boundary of a cavity 7 in the mould is indicated by the dashed line 30.

Various semi-conductor components 1 are generally mounted on the lead frame strip 2 through repetition of the illustrated structure upwards and/or downwards in the figure.

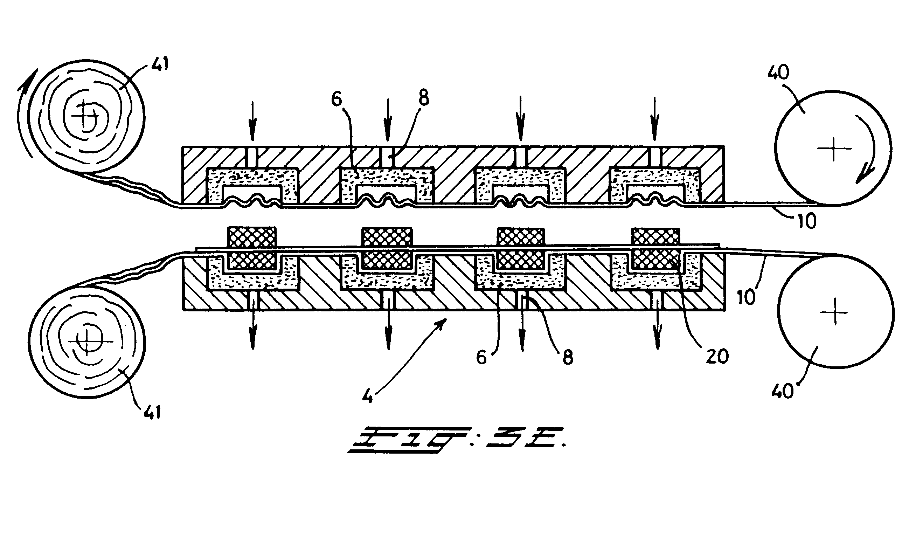

Fig. 3 illustrates in succession in Figs. 3A, 3B, 3C, 3D and 3E the processing steps to be carried out in an embodiment of the method according to the invention. Parts with identical reference numberals to those in Fig. 1 or Fig. 2 are of the same type and have the same function.

Fig. 3A shows an open mould 4, consisting of two parts, between which two flat bands of film 10 are stretched, one for each mould part. Each band of film comes off a stock roll 40, from where the film, after being used once, is rolled onto a second roll 41, as shown in Figs. 3B, 3C, 3D and 3E. For unrolling and rolling up of the film, the rolls 40 and 41 can be, for example, braked and driven in a manner not shown in any further detail, in such a way that the film is held taut in the mould.

Fig. 3B shows the next step. The moulding parts, with the unused bands of film between them, are clamped together, following which the air is extracted through the channels 8 between the porous moulding parts 6 and the film 10. This is symbolized by the arrows facing away from the mould at the channels 8. The film, which is stretchable, is deformed so that it fits closely against the cavities 7, and thus forms a layer on the inside wall of the mould parts.

Fig. 3C shows the subsequent opening of the mould, while the film remains sucked against the moulding parts 6. After the opening, a lead frame strip 2, with in this example four semi-conductor components 1 mounted thereon, is positioned between the mould parts and thereby clamped fast after the mould parts have been brought together.

Fig. 3D illustrates the next step according to the new method, in which a hardening plastic 20 is forced into the cavities provided with semi-conductor components, lead frame strip and film.

Fig. 3E gives an example of the detachment from the closed mould of the semi-conductor components on the lead frame strip encased with set plastic. For this purpose, air can be supplied through the channels 8 of the top mould part to the porous moulding parts 6 of the top mould part (symbolized by the arrows facing the mould at the channels 8), following which the mould is opened. The top film now comes away from the top moulding parts, from the top mould part and from the encased semi-conductor components, since the film does not adhere to the materials in question. The components are detached in a corresponding way from the bottom mould part, following which the components are removed from the mould. The parts of the films 10 used in the mould are then wound onto the rolls 41, following which the situation illustrated in Fig. 3A arises again.

It is possible in this way to repeat this method any desired number of times, determined by the stock of raw and other materials.

The method according to the invention offers particularly interesting applications by using a film bearing on the side facing the component a material which adheres better to the still warm plastic encasing the component than to the film, and thus remains adhering to the plastic encasement following removal thereof from the mould after cooling.

A number of examples will be given below.

If the material consists of a metal coating, a Faraday cage is formed around the component, by means of which the component is protected against incoming electromagnetic radiation, and the discharge of electromagnetic radiation is also suppressed. Moreover, a certain protection against the penetration of moisture is obtained, and radiation in the visible light spectrum and in the ultraviolet spectrum will also be blocked.

A special advantage is that the metal layer offers the possibility of soldering the component in a simple manner to a metal element, for example a cooling element.

Of course, it is also possible to carry out the metal coating in the form of tracks, with the result that after the encasing plastic sets on the component itself a pattern of electrically conducting tracks is left behind, and can be combined with discrete electronic components. It is clear that a multiplicity of interesting and unexpected potential applications is produced here through the "printed circuit" formed on the component.

Partially pressing away the carrier film mass at the transition from the clamping face around the moulding cavity and the moulding cavity itself ensures that the coating is stretched through stretching of the elastic carrier film, in such a way that the non-elastic metal layer can no longer follow this stretch and is interrupted, so that the contacts coming out of the electronic component are prevented from short-circuiting with each other.

A second possibility is the use of a ceramic material. This gives an absolute shielding of the encased component and a considerably improved protection against penetration of moisture, because there are many fewer moisture-absorbent molecules on the external surface of the product thus obtained than is the case with a plastic surface not shielded with ceramic material. This complete sealing against moisture penetration means that there is no risk now of "blowing up" through steam formation, which could occur where there is great local heating during, for example, soldering or if a large quantity of electrical energy is dissipated in the encased component, with the accompanying heat development. Here again, far-reaching protection against radiation from the visible and ultraviolet spectrum can be obtained.

The use of glass as the material which is transferred from the film onto the encasement is particularly interesting. With the measures proposed according to the invention it becomes economically possible for the first time to use very thin glass layers in the form of light-conducting tracks to form complete optical circuits on the external surface of an encased component. In this way it is possible to achieve not only optical circuits, but also to form optoelectronic combinations by combining the glass tracks with, or making them interact with, light-sensitive or radiation-sensitive electronic components or light-transmitting or radiation-transmitting electronic components. This means that it is no longer necessary to use optoelectronic couplers as discrete components. Interruptions can be provided by preventing the transfer at certain points through, for example, selectively applying a second coating as a release agent beforehand.

It should be pointed out that the porous moulding parts 6 shown in Figs. 1 and 3 are not absolutely essential for achieving the object according to the invention.

A single air venting or air supply opening, or a limited number of such openings in the cavity 7, connected to an air channel 8, can replace the porous mould part, this depending on the stretching properties of the film.

A film which has the abovementioned properties is, for example, a polymer film.

Special advantages are obtained if the encasing is carried out in two successive steps. In the first step the mould cavity walls are not yet fully in their end position, and the plastic is injected between the component and the film at such pressure that the film comes to rest sealingly against the moulding cavity walls. Thereafter, the mould cavity walls are taken into the end position, which causes the pressure in the mould cavity to increase sharply, resulting in good sealing of the moulding mass at the critical points where air inclusions are often found if the encasing is carried out in one step. In this case one can use a mould which is not fully closed in the first step, and in the case of which the sealing effect of the film is therefore relied upon for the sealing, but it is preferable to use a mould in which the moulding cavity walls themselves are movable more or less independently of the mould. In the first step the mould is then fully closed, but the moulding cavity walls have not yet reached their definitive end position; the latter is not achieved until the second step, during which the moulding mass is compacted.

With these measures, the tightness of the encasement is considerably improved at the most difficult and most critical points. It has advantages here if a shutoff element is provided in the injection channel.

## Claims

1. Method for encasing an electronic component (1), in particular an integrated circuit, with a hardening plastic (20), in which the component is positioned in the cavity (7) of a splittable mould (4), with a film (10), which is detachable from the walls of the cavity (7), placed between the component (1) and the mould and the plastic (20) being injected into the space between the component (1) and the film (10), characterized in that said film (10) bears at the side facing the component (1) a material consisting of a metal coating or a ceramic or glass which adheres better to the still warm injected plastic (20) encasing said component (1) than to the film, (10) and thus remains adhering to the plastic encasing (20) when the latter is removed from the mould (4) after cooling.

2. Method according to claim 1, **characterized in that** said material is glass.

3. Method according to claim 2, **characterized in that** the glass is applied to the film in a pattern of light-conducting tracks.

4. Method according to claim 3, **characterized in that** these light-conducting tracks are combined with, or made to interact with, light-sensitive or radiation-sensitive electronic components.

5. Method according to claim 3, **characterized in that** these light-conducting tracks are combined with, or made to interact with, light-transmitting or radiation-transmitting electronic components.

6. Method according to claim 1, **characterized in that** the encasing is carried out in at least two successive steps, as follows:
- a first step, in which the moulding cavity (7) walls have not yet fully reached their end position and the plastic (20) is injected between the component and the film (10) at such pressure that the film (10) comes to rest in a sealing manner against the moulding cavity (7) walls, and
- an immediately following second step, in which the moulding cavity walls are moved into the end position.

7. Method according to claim 6, **characterized in that** the injection pressure is maintained during the carrying out of the second step.

## Patentansprüche

1. Verfahren zum Umhüllen eines elektronischen Bauteils (1), insbesondere eines integrierten Schaltkreises, mit einem härtbaren Kunststoff (20), wobei das Bauteil in einer Kavität (7) einer teilbaren Form (4) mit einem Film (10) positioniert wird, der von der Wand der Kavität (7) lösbar und zwischen dem Bauteil (1) und der Form angeordnet ist, und wobei der Kunststoff (20) in den Raum zwischen dem Bauteil (1) und dem Film (10) eingespritzt wird, dadurch gekennzeichnet, daß der Film (10) auf der dem Bauteil (1) gegenüberliegenden Seite ein Material bestehend aus einer Metallschicht oder einer Keramik oder Glas aufweist, das besser am noch warmen eingespritzten Kunststoff (20), der das Bauteil (1) umhüllt, haftet, als an dem Film (10), und so an der Kunststoffhülle (20) verbleibt, wenn diese aus der Form (4) nach dem Abkühlen entnommen wird.

2. Verfahren nach Anspruch 1 dadurch gekennzeichnet, daß das Material Glas ist.

3. Verfahren nach Anspruch 2 dadurch gekennzeichnet, daß das Glas auf den Film in einem Muster lichtleitender Bahnen aufgebracht ist.

4. Verfahren nach Anspruch 3 dadurch gekennzeichnet, daß diese lichtleitenden Bahnen mit licht- oder strahlungsempfindlichen elektronischen Komponenten kombiniert oder so ausgebildet sind, daß sie mit diesen wechselwirken.

5. Verfahren nach Anspruch 3 dadurch gekennzeichnet, daß die lichtleitenden Bahnen mit licht- oder strahlungsdurchlässigen elektronischen Bauteilen kombiniert oder so ausgebildet sind, daß sie mit diesen wechselwirken.

6. Verfahren nach Anspruch 1 dadurch gekennzeichnet, daß die Umhüllung folgendermaßen in wenigstens zwei aufeinanderfolgenden Schritten ausgeführt wird:
- ein erster Schritt, in dem die Wände der Formkavität (7) noch nicht vollständig ihre Endposition erreicht haben und der Kunststoff (20) zwischen das Bauteil und den Film (10) bei einem Druck eingespritzt wird, bei dem der Film (10) in dichtender Weise an die Wände der Formkavität (7) zu liegen kommt, und
- ein unmittelbar folgender zweiter Schritt, in dem die Wände der Formkavität in ihre Endposition gebracht werden.

7. Verfahren nach Anspruch 6 dadurch gekennzeichnet, daß der Einspritzdruck während der Durchführung des zweiten Schritts aufrecht erhalten wird.

## Revendications

1. Méthode pour enfermer un composant électronique (1), en particulier un circuit intégré, avec un plastique durcissable (20) dans lequel le composant est placé dans la cavité (7) d'un moule divisable (4) avec un film (10) qui est détachable des parois de la cavité (7) qui se trouve entre le composant (1) et le moule et le plastique (20) étant injecté dans l'espace entre le composant (1) et le film (10)
caractérisée en ce que ledit film (10) porte sur son côté tourné vers le composant (1) un matériau consistant en un revêtement de métal ou de céramique ou de verre qui adhère mieux au plastique injecté encore chaud (20) enfermant ledit composant (1) au film (10) et ainsi reste en adhérence avec l'enfermement en plastique (20) quand ce dernier est retiré du moule (4) après refroidissement.

2. Méthode selon la revendication 1, caractérisée en ce que ledit matériau est du verre.

3. Méthode selon la revendication 2, caractérisée en ce que le verre est appliqué au film en un motif de pistes conductrices de la lumière.

4. Méthode selon la revendication 3, caractérisée en ce que ces pistes conductrices de la lumière sont combinées avec ou forcées à coopérer avec des composants électroniques sensibles à la lumière ou sensibles au rayonnement.

5. Méthode selon la revendication 3, caractérisée en ce que ces pistes conductrices de la lumière sont combinées avec ou forcées à coopérer avec des composants électroniques transmettant la lumière ou transmettant le rayonnement.

6. Méthode selon la revendication 1, caractérisée en ce que l'enfermement est effectué en au moins deux étapes successives, comme suit :
une première étape dans laquelle les parois de la cavité (7) de moulage n'ont pas encore totalement atteint leur position finale et le plastique (20) est injecté entre le composant et le film (10) à une pression telle que le film (10) vienne reposer d'une manier étanche contre les parois de la cavité de moulage (7) et
une seconde étape suivant immédiatement dans laquelle les parois de la cavité de moulage sont déplacées à la position finale.

7. Méthode selon la revendication 6, caractérisée en ce que la pression d'injection est maintenue pendant que l'o n effectue la seconde étape.
